Europäisches Patentamt

European Patent Office

Office européen des brevets

(19)

(11) Veröffentlichungsnummer: **0 276 449 B1**

(12) # EUROPÄISCHE PATENTSCHRIFT

(45) Veröffentlichungstag der Patentschrift: **25.11.92**

(51) Int. Cl.⁵: **H03K 4/06**

(21) Anmeldenummer: **87118622.7**

(22) Anmeldetag: **16.12.87**

(54) **Verfahren zur Erzeugung einer Spannung mit dreieckförmigem Kurvenverlauf.**

(30) Priorität: **23.01.87 DE 3701927**

(43) Veröffentlichungstag der Anmeldung:
**03.08.88 Patentblatt 88/31**

(45) Bekanntmachung des Hinweises auf die
Patenterteilung:
**25.11.92 Patentblatt 92/48**

(84) Benannte Vertragsstaaten:
**AT BE CH DE ES FR GB IT LI LU NL SE**

(56) Entgegenhaltungen:
**FR-A- 2 503 487**
**US-A- 3 911 295**

**IBM TECHNICAL DISCLOSURE BULLETIN,
Band 13, Nr. 6, November 1970, Seiten
1405,1406, New York, US; L. E. AMBRICO:
"CRT distortion correction circuit"**

(73) Patentinhaber: **Deutsche Thomson-Brandt
GmbH
Hermann-Schwer-Strasse 3 Postfach 1307
W-7730 Villingen-Schwenningen(DE)**

(72) Erfinder: **Hartmann, Uwe
Tallardstrasse 15
W-7730 Villingen-Schwenningen(DE)**
Erfinder: **Ohnemus, Fritz
An der Hammerhalde 13
W-7730 Villingen-Schwenningen(DE)**

**Beschreibung**

Die vorliegende Erfindung betrifft ein Verfahren zur Erzeugung einer Spannung mit dreieckförmigem Kurvenverlauf. Derartige Spannungen werden zur Erzeugung eines Korrekturstromes z.B. für die Vertikalablenkung in Fernsehempfängern benötigt. Die Ablenkung der Elektronenstrahlen erfolgt bekanntlich mit Hilfe von sägezahnförmigen Ablenkströmen. Für bestimmte Bildröhren sind Korrekturschaltungen notwendig, die eine phasengetreue Grundwelle zur Frequenz des Ablenkstromes erzeugen müssen. Bekannt sind z.B. die Verwendung von Filterschaltungen oder auch von synchronisierten Oszillatorschaltungen, wobei jedoch eine Abstimmung auf die Grundwelle erfolgen muß, wozu zusätzlicher Schaltungsauswand mit den entsprechenden Kosten notwendig ist. Insbesondere, wenn die Schaltung für mehrere Vertikalablenkfrequenzen wahlweise geeignet sein soll, müssen diese Korrekturschaltungen auf die entsprechende Ablenkfrequenz abgeglichen werden. Die Verwendung unterschiedlicher Ablenkfrequenzen ist sehr aktuell zwecks höherer Bildauflösung und zwecks Vermeidung von störenden Flackererscheinungen auf dem Bildschirm. Zukünftige Fernsehempfänger werden in der Lage sein, Ablenkfrequenzen mit 50, 60, 100 oder auch 120 Hz zu verarbeiten.

Es ist bekannt, zur Beseitigung von Kissenverzerrunge auf dem Bildschirm eines Fernsehempfängers aus zwei Hälften des vertikalfrequenten, sägezahnförmigen Ablenksignals über zwei Dioden ein Korrektursignal zu erzeugen, wobei die beiden Sägezahnhälften asymmetrisch verstellbar sind. Hierbei handelt es sich um einen abfallenden und einen von der Mitte der Ablenkperiode ansteigenden Ast der sägezahnförmigen Signale. Der Nulldurchgang des Wechselspannungsanteils des resultierenden Signals liegt daher nicht in der Mitte der Ablenkperiode, sondern bei Pi/2 und bei 3*Pi/2 (IBM Technical Disclosure Bulletin, vol. 13, no. 6, November 1970, S. 1405-1406, "CRT Distortion Correction Circuit").

Auch ist bekannt, einen Korrekturstrom mit Hilfe einer Diodenbrücke zu erzeugen, wobei dieser Korrekturstrom durch entsprechende Vorspannungen der Dioden einen annähernd parabelförmigen Verlauf erhält. Auch hier liegt der Scheitelpunkt der Parabel irgendwo in der Mitte der Ablenkperiode (US-A-3 911 295). Ein derartiger Kurvenverlauf ist jedoch nicht geeignet, die der Erfindung zugrunde liegende Aufgabe zu lösen, die darin besteht, ein Verfahren zu finden, um eine frequenzunabhängige Grundwelle für eine Korrektur zu erzeugen, welche mit dem Vertikalablenkstrom phasengleich ist, wobei teurer Schaltungsaufwand vermieden werden soll und kein Abgleich in Abhängigkeit von der Frequenz des Ablenkstroms benötigt wird.

Der Erfindung liegt die Aufgabe zugrunde, ein Verfahren zu finden, um eine frequenzunabhängige Grundwelle für eine Korrektur zu erzeugen, welche mit dem Vertikalablenkstrom phasengleich ist, wobei teurer Schaltungsaufwand vermieden werden soll, die keinen Abgleich in Abhängigkeit von der Frequenz des Ablenkstromes benötigt. Diese Aufgabe wird durch die in den Patentansprüchen 1 und 2 gekennzeichneten Maßnahmen gelöst. Weitere Ausgestaltungen der Erfindung ergeben sich aus den Unteransprüchen.

Nachstehend wird die Erfindung an einem Ausführungsbeispiel erläutert.

Figur 1
zeigt ein Prinzipschaltbild zur Durchführung des angemeldeten Verfahrens;
Figur 2.1 und 2.2
zeigen Diagramme zur Erläuterung der Entstehung des erforderlichen dreieckförmigen Kurvenverlaufs;
Figur 3
zeigt ein detailliertes Schaltbild zur Durchführung des Verfahrens.

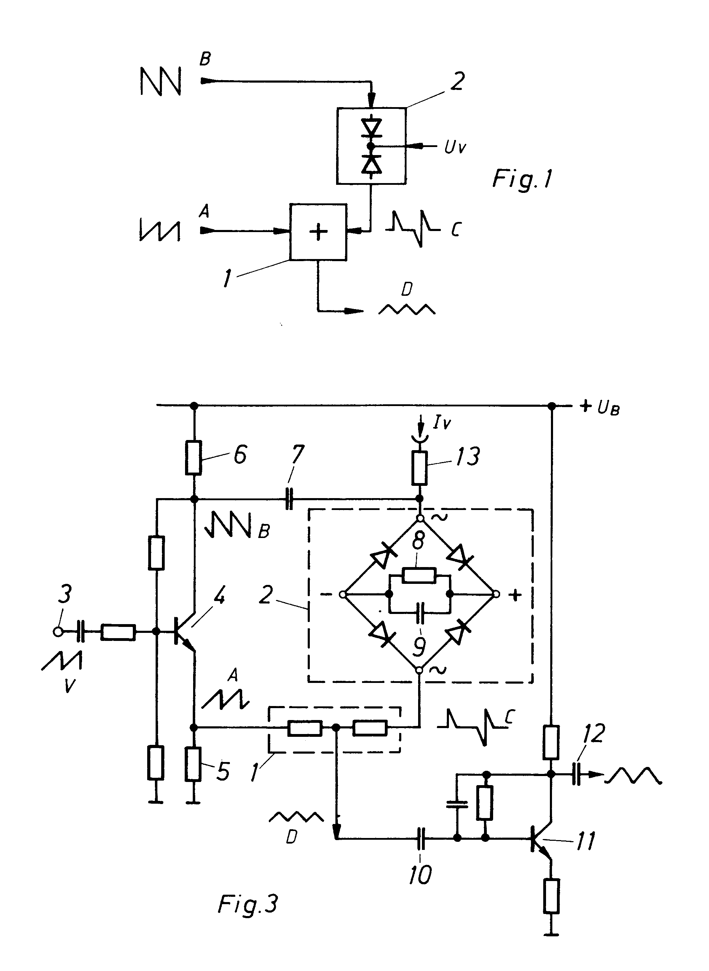

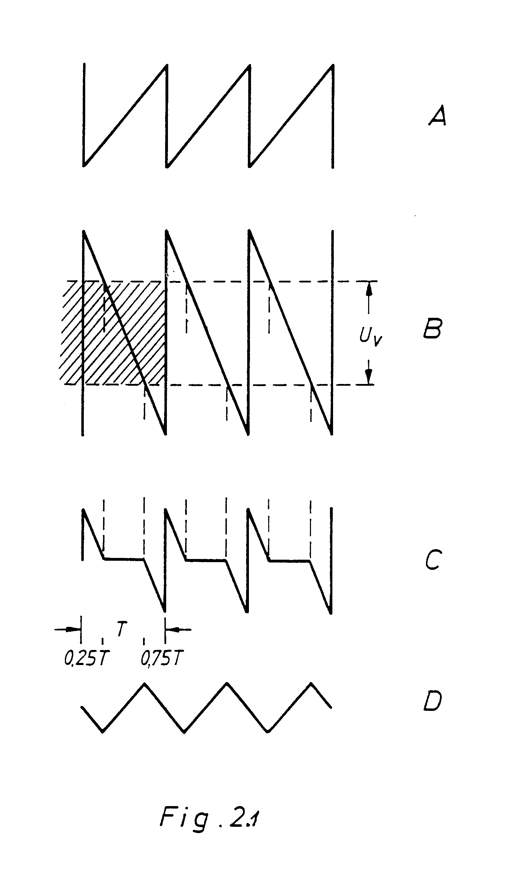

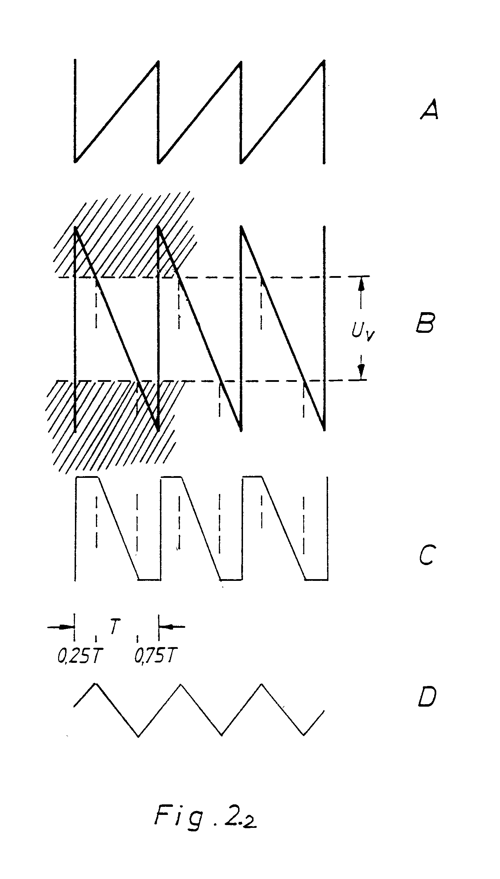

In Figur 1 wird dem einen Eingang einer Additionsschaltung 1 eine erste Spannung mit sägezahnförmigem Kurvenverlauf zugeführt. Eine zweite zur ersten Spannung mit sägezahnförmigem Kurvenverlauf gegenphasige Spannung mit einem zur ersten sägezahnförmigen Spannung zweifachen Amplitude wird einer Diodenbrücke 2 zugeführt. Diese Diodenbrücke 2 ist über eine symbolisch angedeutete Spannung $U_V$ vorgespannt. Am Ausgang der Diodenbrücke 2 entsteht eine sägezahnartige Spannung mit teilweise durch die Vorspannung $U_V$ bedingten waagerechten Teilen, die dem anderen Eingang der Additionsschaltung 1 zugeführt wird. Durch die Addition ergibt sich am Ausgang dieser Additionsschaltung 1 die Spannung mit dem dreiecksförmigen Kurvenverlauf. Dies wird mit Hilfe der Figur 2.1 an den Diagrammen erläutert. Kurve A bezeichnet den Spannungsverlauf, die dem einen Eingang der Additionsschaltung 1 zugeführt wird. Kurve B, deren Spitzenwert doppelt so groß ist wie derjenige der Kurve A, ist gegenphasig zur Kurve A. Dieser Spannungsverlauf gelangt an den Eingang der Diodenbrükke 2. Die Vorspannung $U_V$ ist in die Kurve B eingetragen. Nur die Spitzen der Kurve B gelangen über die Diodenbrücke 2 an deren Ausgang, so daß waagerechte Teilbereiche entstehen, wie in der Kurve C dargestellt ist. Die Spitzenwerte der Kurve A und der Kurve C müssen gleich sein. Durch Addition der beiden Kurven A und C entsteht die Kurve D mit dem gewünschten dreiecksförmigen Kurvenlauf.

In Figur 2.2 ist eine weitere Möglichkeit zur Erzeugung der dreieckförmigen Spannung dargestellt, wenn der Verlauf gemäß Kurve C nach Anspruch 2 erzeugt wird. Die Begrenzung des Signalverlaufs gemäß Kurve B kann z.B. mit Hilfe von Dioden erfolgen.

Mit Hilfe der Figur 3 wird das angemeldete Verfahren an einem detaillierten Ausführungsbeispiel einer Schaltungsanordnung beschrieben. Dem Eingang 3 einer Verstärkerstufe 4 wird das vertikalfrequente sägezahnförmige Signal V zugeführt. Das dem Signal V gleichphasige sägezahnförmige Signal A wird am Emitterwiderstand 5 der Verstärkerstufe 4 abgenommen und der Additionsschaltung 1 zugeführt. Am Kollektorwiderstand 6 der Verstärkerstufe 4 wird das dem Signal V gegenphasige sägezahnförmige Signal B abgenommen und über den Kondensator 7 einer Diodenbrücke 2 zugeführt. Durch die Signalspitzen der Spannung B entsteht an dem RC-Glied 8, 9 eine Vorspannung für die Diodenbrücke 2. Am Ausgang der Diodenbrücke 2 entsteht die sägezahnartige Signalspannung C mit den durch die Vorspannung bewirkten waagerechten Teilen. Das Signal C wird dem anderen Eingang der Additionsscaltung 1 zugeführt. Am Ausgang der Additionsschaltung 1 entsteht das Signal D, welches über einen Kondensator 10 einem Verstärker 11 zugeführt wird. Das dreieckförmige Signal D wird über den Kondensator 12 ausgekoppelt. Der mittlere waagerechte Teil des Signals C bleibt in seiner zeitlichen Länge auch bei Toleranzen der Eingangsspannung weitgehend erhalten, wenn eine mitlaufende Gleichspannung mittels des RC-Gliedes 8, 9 unterdrückt wird. Der Widerstand 8 des RC-Gliedes 8, 9 bestimmt die Entladezeit des Kondensators 9, so daß hiermit die gewünschte Zeitdauer des waagerechten Teils des Signals C bestimmt wird. Wegen der mitlaufenden Ladespannung des Kondensators 9 kann die Eingangsspannung um z.B. +/- 15 % schwanken, ohne daß der zusammenhängende Kurvenverlauf des Signals C gestört wird. Durch das Fehlen frequenzabhängiger Glieder ist diese Anordnung in einem großen Frequenzbereich verwendbar. So kann die Schaltungsanordnung z.B. Frequenzen von 40 bis 200 Hz verarbeiten. Zwecks Phasenverschiebung des Signals D kann ein Vorstrom $I_V$ über einen Widerstand 13 in die Diodenbrücke 2 eingeleitet werden. Es können somit Phasenverschiebungen von +/- 90 Grad des Signals D erzielt werden.

**Patentansprüche**

1. Verfahren zur Erzeugung einer Spannung mit dreieckförmigem Kurvenverlauf (D) durch Addition einer sägezahnförmigen ersten Spannung (A) zu einer sägezahnartigen Spannung (C) mit gleichen Spitzenwerten, **dadurch gekennzeichnet,** daß die sägezahnartige Spannung (C) durch Unterdrücken eines zur Mittellinie symmetrischen Teiles ($U_V$) einer zur ersten sägezahnförmigen Spannung (A) gegenphasigen zweiten sägezahnförmigen Spannung doppelter Amplitude (B) derart umgeformt wird, daß sie im Zeitabschnitt 0,25T bis 0,75T waagerechte Abschnitte der Amplitude Null besitzt, und daß die Addition der sägezahnförmigen Spannung (A) zu der gegenphasigen sägezahnartigen, mit den waagerechten Abschnitten versehenen Spannung (C) derart erfolgt, daß der dreieckförmigen Kurvenverlauf (D) Nulldurchgänge bei Null, 0,5T und T der Periode T aufweist.

2. Verfahren zur Erzeugung einer Spannung mit dreieckförmigem Kurvenverlauf (D) durch Addition einer sägezahnförmigen ersten Spannung (A) zu einer sägezahnartigen Spannung (C) mit gleichen Spitzenwerten **dadurch gekennzeichnet,** daß die sägezahnartige Spannung (C) durch Begrenzen auf einen zur Mittellinie symmetrischen Teil ($U_V$) einer zur sägezahnförmigen ersten Spannung (A) gegenphasigen sägezahnförmigen zweiten Spannung doppelter Amplitude derart umgeformt wird, daß sie in den Zeitabschnitten Null bis 0,25T und 0,75T bis T waagerechte Abschnitte der genannten Amplitude besitzt, und daß die Addition der sägezahnförmigen ersten Spannung (A) zu der gegenphasigen sägezahnartigen, mit den waagerechten Abschnitten versehenen Spannung (C) derart erfolgt, daß der dreieckförmige Kurvenverlauf (D) Nulldurchgänge bei Null, 0.5T und T der Periode T aufweist.

3. Verfahren nach Anspruch 1, **dadurch gekennzeichnet,** daß der sägezahnartige Spannungsverlauf (C) mit den waagerechten Abschnitten dadurch erzeugt wird, daß eine sägezahnförmige zweite Spannung (B) mit einem im Verhältnis zur sägezahnförmigen ersten Spannung (A) doppelten Spitzenwert (B) über eine entsprechend vorgespannte Diodenbrücke (2) geleitet wird.

4. Verfahren nach Anspruch 3, **dadurch gekennzeichnet,** daß die Vorspannung der Diodenbrücke (2) mit Hilfe einer Batteriespannung ($U_V$) erzeugt wird.

5. Verfahren nach Anspruch 3, **dadurch gekennzeichnet,** daß die Vorspannung mit Hilfe einer die Gleichspannungspole der Diodenbrücke (2) verbindenden Parallelschaltung eines Kondensators (9) und eines Widerstandes (8) erzeugt wird.

6. Schaltungsanordnung zur Durchführung des Verfahrens nach den Ansprüchen 1, 3, 4 oder 5, **dadurch gekennzeichnet,** daß eine erste Spannung (A) mit sägezahnförmigen Kurvenverlauf dem einen Anschluß einer Additionsschaltung (1) zugeführt ist und eine zur ersten Spannung (A) mit sägezahnförmigem Kurvenverlauf gegenphasige zweite Spannung mit sägezahnförmigen Kurvenverlauf mit gegenüber der ersten Spannung doppeltem Spitzenwert über eine bzw. die vorgespannte Diodenbrücke (2) dem anderen Anschluß der Additionsschaltung (1) zugeführt wird, an deren Ausgang die Spannung mit dreieckförmigen Kurvenverlauf abnehmbar ist.

7. Schaltungsanordnung nach Anspruch 6, **dadurch gekennzeichnet,** daß der Diodenbrükke (2) ein positiver oder negativer Vorstrom ($I_V$) zuführbar ist, damit eine Phasenverschiebung der Spannung (D) mit dereieckförmigem Kurvenverlauf von plus/minus 90 Grad erreichbar ist.

## Claims

1. Method of producing a voltage with a triangular-shaped curve path (D) by addition of a saw-tooth-shaped first voltage (A) to a saw-tooth-type voltage (C) with the same peak values, **characterised in that** the saw-tooth-type voltage (C) is, by suppression of a part ($U_V$), symmetrical to the centre line, of a second saw-tooth-shaped voltage with twice the amplitude (B) and of opposite phase to the first saw-tooth-shaped voltage (A), transformed in such a way that it possesses in the time interval 0.25T to 0.75T horizontal sections of zero amplitude, and that the addition of the saw-tooth-shaped voltage (A) to the saw-tooth-type voltage of opposite phase (C) provided with the horizontal sections takes place in such a way that the triangular-shaped curve path (D) exhibits passings through zero at zero, 0.5T and T of the period T.

2. Method of producing a voltage with a triangular-shaped curve path (D) by addition of a saw-tooth-shaped first voltage (A) to a saw-tooth-type voltage (C) with the same peak values, **characterised in that** the saw-tooth-type voltage (C) is, by limitation to a part ($U_V$), symmetrical to the centre line, of a saw-tooth-shaped second voltage with twice the amplitude and of opposite phase to the saw-tooth-shaped first voltage (A), transformed in such a way that it possesses in the time intervals zero to 0.25T and 0.75T to T horizontal sections of the above-mentioned amplitude, and that the addition of the saw-tooth-shaped first voltage (A) to the saw-tooth-type voltage of opposite phase (C) provided with the horizontal sections takes place in such a way that the triangular-shaped curve path (D) exhibits passings through zero at zero 0.5T and T of the period T.

3. Method according to claim 1. **characterised in that** the saw-tooth-type voltage curve path (C) with the horizontal sections is produced by a saw-tooth-shaped second voltage (B) with twice the peak value (B) compared with the saw-tooth-shaped first voltage (A) being passed across a suitably biassed diode bridge (2).

4. Method according to claim 3, **characterised in that** the bias voltage of the diode bridge (2) is produced by means of a battery voltage ($U_V$).

5. Method according to claim 3, **characterised in that** the bias voltage is produced by means of a parallel circuit consisting of a capacitor (9) and a resistor (8) and connecting the d.c. voltage terminals of the diode bridge (2).

6. Circuit arrangement for carrying out the method according to claims 1, 3, 4 or 5, **characterised in that** a first voltage (A) with a saw-tooth-shaped curve path is supplied to the one terminal of an adder circuit (1) and a second voltage with a saw-tooth-shaped curve path in opposite phase to the first voltage (A) with a saw-tooth-shaped curve path and with twice the peak value compared with the first voltage is supplied via a or the biassed diode bridge (2) to the other terminal of the adder circuit (1), at the output of which the voltage with a triangular-shaped curve path may be picked off.

7. Circuit arrangement according to claim 6, **characterised in that** there is suppliable to the diode bridge (2) a positive or negative bias current ($I_V$), so that a phase shift of the voltage (D) with a triangular-shaped curve path of plus/minus 90 degrees is achievable.

## Revendications

1. Procédé pour produire une tension avec une courbe en triangle (D) par addition d'une première tension en dent de scie (A) et d'une tension du type dent de scie (C) avec les mêmes valeurs de crête, **caractérisé en ce** que la tension du type dent de scie (C) est transformée, en supprimant une partie symétrique ($U_V$) par rapport à la ligne centrale d'une seconde tension en dent de scie, d'amplitude double, de phase opposée à la première tension en dent de scie (A), de telle manière qu'elle possède des sections horizontales d'amplitude zéro dans la période de 0,25T à 0,75T et que l'addition de la tension en dent de scie (A) et de la tension du type dent de scie (C) de phase opposée, avec les portions horizontales, se fait de telle manière que la courbe en forme de triangle (D) présente des passages par zéro à zéro, 0,5T et T de la période T.

2. Procédé pour produire une tension avec une courbe en triangle (D) par addition d'une première tension en dent de scie (A) et d'une tension du type dent de scie (C) avec les mêmes valeurs de crête, **caractérisé en ce** que la tension du type dent de scie (C) est transformée, par limitation à une partie symétrique ($U_v$) par rapport à la ligne centrale d'une seconde tension en dent de scie, d'amplitude double, de phase opposée à la première tension en dent de scie (A), de telle manière qu'elle possède des sections horizontales de l'amplitude citée dans la période de 0 à 0,25T à 0.75T à T et que l'addition de la tension en dent de scie (A) et de la tension du type dent de scie (C) de phase opposée, avec les portions horizontales, se fait de telle manière que la courbe en forme de triangle (D) présente des passages par zéro à zéro, 0,5T et T de la période T.

3. Procédé selon la revendication 1, **caractérisé en ce** que la courbe de tension de type dent de scie (C) avec les sections horizontales est produite par le fait qu'une seconde tension en dent de scie (B) avec une valeur de crête (B) qui est le double par rapport à celle de la première tension en dent de scie (A) passe par un pont à diodes (2) de précontrainte correspondante.

4. Procédé selon la revendication 3, **caractérisé en ce** que la précontrainte du pont à diodes (2) est réalisée à l'aide d'une tension de batterie ($U_v$).

5. Procédé selon la revendication 3, **caractérisé en ce** que la précontrainte est réalisée à l'aide d'un montage en parallèle d'un condensateur (9) et d'une résistance (8) qui relie les pôles de tension continue du pont à diodes (2).

6. Dispositif de circuit pour la réalisation du procédé selon les revendications 1, 3, 4 ou 5, **caractérisé en ce** qu'une première tension (A) avec une courbe en dent de scie est amenée à l'un des raccords d'un circuit addeur (1) et une seconde tension avec une courbe en dent de scie, de phase opposée à la première tension (A) avec une courbe en dent de scie, avec une valeur de crête qui est le double de celle de la première tension est amenée par un ou le pont à diodes (2) polarisé à l'autre raccord du circuit addeur (1) à la sortie duquel la tension avec la courbe en triangle peut être prélevée.

7. Dispositif de circuit selon la revendication 6, **caractérisé en ce** qu'un courant de précontrainte positif ou négatif ($I_v$) peut être amené au pont à diodes (2) pour pouvoir obtenir un décalage de phase de la tension (D) avec une courbe en triangle de plus ou moins 90 degrés.

Fig.1

Fig.3

Fig. 2.1

$A$

$B$

$U_V$

$C$

$T$

$0,25T$    $0,75T$

$D$

Fig. 2.2